# EUROPEAN PATENT APPLICATION

(11) **EP 4 145 449 A1**
(43) Date of publication of application: **08.03.2023**
(21) Application number: 20938336.3
(22) Date of filing: 27.05.2020
(51) Int. Cl.: G11C 11/16

(54) **MAGNETIC RANDOM ACCESS MEMORY, DATA READ-WRITE METHOD, AND ELECTRONIC DEVICE**

(71) Applicant: Huawei Technologies Co., Ltd., Longgang District, Shenzhen, Guangdong 518129 (CN)
(72) Inventor: LI, Wenjing, Shenzhen, Guangdong 518129 (CN); YE, Li, Shenzhen, Guangdong 518129 (CN)
(74) Representative: Maiwald GmbH
(86) International application number: PCT/CN2020/092515
(87) International publication number: WO 2021/237497

(57) **Abstract**

A magnetic random access memory is provided, to improve a storage density of the magnetic random access memory. The magnetic random access memory includes a plurality of structural units (202) and a plurality of voltage control lines (203). The plurality of voltage control lines (203) are parallel. Planes on which the plurality of structural units (202) are located are parallel. A plane on which each structural unit (202) of the plurality of structural units (202) is located is perpendicular to the plurality of voltage control lines (203). Each of the plurality of structural units (202) includes a plurality of storage strings (204) parallel to each other. Each of the plurality of storage strings (204) includes a plurality of layers of storage structures that are sequentially stacked. Each layer of storage structure includes a spin-orbit torque SOT electrode line perpendicular to the plurality of voltage control lines (203) and a storage unit (201) disposed on the SOT electrode line. The storage unit (201) includes a magnetic tunnel junction. One terminal of the storage unit (201) is connected to one of the plurality of voltage control lines (203). The other terminal of the storage unit (201) is connected to the SOT electrode line. All SOT electrode lines in each storage string (204) are connected in series by using metal wires.

## Description

### TECHNICAL FIELD

Embodiments of this application relate to the field of storage technologies, and in particular, to a magnetic random access memory and an electronic device.

### BACKGROUND

Development of information technologies poses a higher requirement on a capacity, a speed, power consumption, stability, and the like of a storage medium. Compared with a conventional semiconductor storage technology, a magnetic random access memory (magnetic random access memory, MRAM) in which a magnetic tunnel junction (magnetic tunnel junction, MTJ) is used as a storage unit has many excellent features such as non-volatility of stored data, a fast read/write speed, an indefinite quantity of erasure times, and low read/write power consumption, and therefore is considered to be a storage technology with a great application prospect.

A core storage unit of the MRAM is an MTJ, and a core structure of the MTJ includes a free layer, a tunnel layer, and a pinning layer. A magnetic moment direction of the pinning layer is fixed, and a magnetic moment direction of the free layer may be changed. When data is written to the MTJ, different data may be written by changing the magnetic moment direction of the free layer (that is, controlling magnetic moments of the free layer and the pinning layer of the MTJ to be arranged in a parallel or antiparallel manner). When data is read from the MTJ, data may be read by determining a high/low resistance state of the MTJ.

In a conventional technology, a storage array of the MRAM is generally two-dimensional (2 dimensions, 2D). To improve a storage density of the MRAM, generally, a dimension and a pitch of the MTJ are continuously reduced to increase a quantity of storage units per unit of area. In this manner, although the storage density of the MRAM may be improved to an extent, when the dimension of the MTJ is reduced to an extent, thermal stability of the MTJ decreases, and data storage reliability decreases.

Therefore, an MRAM storage array solution is urgently required, to improve the storage density of the MRAM.

### SUMMARY

Embodiments of this application provide a magnetic random access memory, a data read/write method for a magnetic random access memory, and an electronic device, to improve a storage density of the magnetic random access memory.

A first aspect of the embodiments of this application provides a magnetic random access memory, where the magnetic random access memory includes a plurality of structural units and a plurality of voltage control lines, planes on which the structural units are located are parallel to each other, and all voltage control lines are perpendicular to each plane; and each structural unit includes a plurality of storage strings parallel to each other, each storage string includes a plurality of layers of storage structures that are sequentially stacked, each layer of storage structure includes a spin-orbit torque SOT electrode line perpendicular to the voltage control line and a storage unit disposed on the SOT electrode line, the storage unit is a magnetic tunnel junction, one terminal of the magnetic tunnel junction is connected to one of the plurality of voltage control lines, the other terminal of the storage unit is connected to an SOT electrode line of a layer of storage structure at which the storage unit is located, and all SOT electrode lines in each storage string are connected in series by using metal wires.

Each magnetic tunnel junction includes a free layer, a barrier layer, and a reference layer that are sequentially stacked, the free layer is connected to the SOT electrode line, and the reference layer is connected to the voltage control line.

According to the magnetic random access memory provided in the first aspect, a storage array is three-dimensional (3 dimensions, 3D). Therefore, compared with a 2D array in a conventional technology, in this solution, while thermal stability of the storage unit is ensured, an areal storage density can be increased by stacking the storage units in a vertical direction, to improve a storage density of the magnetic random access memory. In addition, in the magnetic random access memory, SOT electrode lines corresponding to storage units of a plurality of layers of storage structures in the vertical direction are connected in series by using metal wires to form one storage string. Therefore, when data is written to the magnetic random access memory or data is read from the magnetic random access memory, a corresponding read/write current may be applied, by using one bit line, to a plurality of SOT electrode lines that are of the plurality of layers of storage structures and whose locations correspond to each other, to reduce line arrangement space of the bit line on a plane of a peripheral circuit, and implement addressing and access on the plurality of layers of storage structures in the magnetic random access memory by using a small quantity of bit lines.

In a possible design, each storage string in the magnetic random access memory further includes a transistor, a drain/source of the transistor is connected to a first terminal of the storage string, the plurality of storage strings are connected in the magnetic random access memory by using a plurality of first bit lines and a plurality of word lines, the plurality of first bit lines and the plurality of word lines are parallel to each other, and are perpendicular to the plurality of voltage control lines, second terminals of all storage strings belonging to a same structural unit are connected to a same first bit line, and gates of transistors in all storage strings belonging to a same structural unit are connected to a same word line.

In a possible design, the magnetic random access memory further includes a plurality of second bit lines, the second bit line and the voltage control line are parallel to each other, and in one storage string, one terminal of the storage string is connected to the first bit line, and the other terminal connected to the transistor is connected to the second bit line.

In the foregoing design, transistors in storage strings belonging to a same structural unit may be turned on by applying a gate bias voltage to one word line, and different voltages are applied to a corresponding first bit line and a corresponding second bit line, so that a read/write current flows through all SOT electrode lines corresponding to one storage string.

In a possible design, the magnetic random access memory further includes a plurality of third bit lines, the third bit line is used to connect the plurality of voltage control lines, and each third bit line is used to connect and control, by using metal wires, all voltage control lines corresponding to one entire layer of storage structures of the plurality of layers of storage structures.

In the foregoing design, voltage control lines corresponding to one layer of storage structures are connected by using one third bit line. Therefore, when data is written to the magnetic random access memory or data is read from the magnetic random access memory, a corresponding voltage may be applied, by using one third bit line, to a plurality of voltage control lines corresponding to one layer of storage structures, to reduce line arrangement space of the bit line on a plane of a peripheral circuit, and apply a corresponding voltage to one storage unit in one storage string by applying different voltages to different third bit lines.

In a possible design, there may be a plurality of connection manners in which all SOT electrode lines in each storage string are connected in series. The following is described by using two connection manners as an example:

### Manner 1

In each storage string, SOT electrode lines are sequentially stacked, and a manner in which the SOT electrode lines are connected in series is as follows: A first terminal of an SOT electrode line of an N^{th} layer of storage structure is connected to a first terminal of an SOT electrode line of an (N+1)^{th} layer of storage structure by using a metal wire, and a second terminal of the SOT electrode line of the (N+1)^{th} layer of storage structure is connected to a second terminal of an SOT electrode line of an (N+2)^{th} layer of storage structure.

### Manner 2

In each storage string, SOT electrode lines are sequentially stacked, and a manner in which the SOT electrode lines are connected in series is as follows: A first terminal of an SOT electrode line of an N^{th} layer of storage structure is connected to a second terminal of an SOT electrode line of an (N+1)^{th} layer storage structure by using a metal wire.

Data may be written to and read from the magnetic random access memory provided in the first aspect in the following manner: When data is written to the magnetic random access memory, first, a gate bias voltage is applied, by using a word line corresponding to a structural unit to which a to-be-written storage unit belongs, to a transistor in a storage string to which the to-be-written storage unit belongs. Next, a write voltage is applied to a first bit line corresponding to the storage string, and a second bit line corresponding to the storage string is grounded. This is equivalent to selecting the storage string in which the storage unit is located, so that a write current exists on SOT electrode lines corresponding to a plurality of storage units in the storage string. In one storage string, all storage units are located at different layers, and different layers correspond to different voltage control lines. Therefore, a bias voltage is applied to a third bit line corresponding to a voltage control line connected to the to-be-written storage unit, so that corresponding data can be written based on a spin-orbit torque (spin-orbit torque, SOT) effect and a voltage-controlled magnetic anisotropy (voltage-controlled magnetic anisotropy, VCMA) principle. When different data is written to the magnetic random access memory, a first bit line corresponding to a storage string to which a to-be-written storage unit belongs may be grounded, and a write voltage is applied to a second bit line, to select the storage string in which the storage unit is located, so that a reverse write current exists on SOT electrode lines corresponding to a plurality of storage units in the storage string. Then, a bias voltage is applied to a third bit line corresponding to a voltage control line connected to the to-be-written storage unit, so that different data is written.

In the foregoing solution, different gate bias voltages may be applied to the word line, so that only all transistors in the structural unit to which the to-be-written storage unit belongs are turned on, and a transistor in another structural unit is not turned on. Therefore, different voltages are applied to the first bit line and the second bit line, so that the write current only flows through the SOT electrode lines in the storage string to which the to-be-written storage unit belongs. In addition, the write bias voltage is applied to the third bit line corresponding to the voltage control line connected to the to-be-written storage unit, and a non-write bias voltage is applied to another third bit line. Therefore, under an action of both the write current and the write voltage, only the to-be-written unit completes information write, and information in another storage unit remains unchanged.

When data is read from the magnetic random access memory, data in all storage units in one storage string is read at one time. First, a word line corresponding to a structural unit to which a to-be-read storage string belongs is determined. Next, a gate bias voltage is applied to a transistor in the to-be-read storage string by using the word line, so that the transistor in the storage string is turned on. Then, a read voltage is applied to a first bit line corresponding to the structural unit to which the to-be-read storage string belongs, and a second bit line corresponding to the to-be-read storage string is grounded. In addition, a read voltage is applied to all other first bit lines and second bit lines, and a read voltage is applied to all third bit lines, to read data in the entire storage string at one time.

A second aspect of the embodiments of this application provides a data write method for a random access memory, including:
the magnetic random access memory includes a plurality of structural units, a plurality of voltage control lines, a plurality of first bit lines, a plurality of second bit lines, and a plurality of word lines, where the voltage control lines are parallel to the second bit lines, the first bit lines are parallel to the word lines, the voltage control lines are perpendicular to the first bit lines, planes on which the plurality of structural units are located are parallel to each other, each structural unit includes a plurality of storage strings parallel to each other, each storage string includes a plurality of layers of storage structure that are sequentially stacked and a transistor, each layer of storage structure includes a spin-orbit torque SOT electrode line and a storage unit disposed on the SOT electrode line, the storage unit may be a magnetic tunnel junction, one terminal thereof is connected to the voltage control line, the other terminal thereof is connected to the SOT electrode line, the SOT electrode line and the voltage control line are perpendicular to each other, all SOT electrode lines in each storage string are connected in series by using metal wires, one first bit line and one word line are shared in each structural unit, first terminals of all storage strings in each structural unit are connected to a same first bit line, gates of transistors in all storage strings are connected to a same word line, a second terminal of the storage string is connected to a first terminal of the transistor, and a second terminal of the transistor is connected to the second bit line.

When data is written to a to-be-written storage unit, first, a structural unit to which the to-be-written storage unit belongs is determined. Next, a gate bias voltage is applied, by using a word line corresponding to the structural unit, to a transistor in a storage string to which the to-be-written storage unit belongs, so that storage strings in the entire structural unit are turned on. Then, a write voltage is applied to the storage unit by using a first bit line corresponding to the structural unit, and a second bit line corresponding to the storage string to which the to-be-written storage unit belongs is grounded. In this way, the storage string to which the to-be-written storage unit belongs is selected, so that a write current exists on SOT electrode lines in the storage string. Subsequently, a bias voltage is applied to the storage unit by using a voltage control line connected to the to-be-written storage unit. In this way, the to-be-written storage unit is selected. Then, data is written to the to-be-written storage unit based on the write voltage and the bias voltage.

A third aspect of the embodiments of this application provides a data write method for a random access memory, including:
the magnetic random access memory includes a plurality of structural units, a plurality of voltage control lines, a plurality of first bit lines, a plurality of second bit lines, and a plurality of word lines, where the voltage control lines are parallel to the second bit lines, the first bit lines are parallel to the word lines, the voltage control lines are perpendicular to the first bit lines, planes on which the plurality of structural units are located are parallel to each other, each structural unit includes a plurality of storage strings parallel to each other, each storage string includes a plurality of layers of storage structure that are sequentially stacked and a transistor, each layer of storage structure includes a spin-orbit torque SOT electrode line and a storage unit disposed on the SOT electrode line, the storage unit may be a magnetic tunnel junction, one terminal thereof is connected to the voltage control line, the other terminal thereof is connected to the SOT electrode line, the SOT electrode line and the voltage control line are perpendicular to each other, all SOT electrode lines in each storage string are connected in series by using metal wires, one first bit line and one word line are shared in each structural unit, first terminals of all storage strings in each structural unit are connected to a same first bit line, gates of transistors in all storage strings are connected to a same word line, a second terminal of the storage string is connected to a first terminal of the transistor, and a second terminal of the transistor is connected to the second bit line.

When data is written to a to-be-written storage unit, first, a structural unit to which the to-be-written storage unit belongs is determined. Next, a gate bias voltage is applied, by using a word line corresponding to the structural unit, to a transistor in a storage string to which the to-be-written storage unit belongs, so that storage strings in the entire structural unit are turned on. Then, a write voltage is applied to a second bit line corresponding to the storage string to which the to-be-written storage unit belongs, and a first bit line corresponding to the structural unit is grounded. In this way, the storage string to which the to-be-written storage unit belongs is selected, so that a write current exists on SOT electrode lines in the storage string. Subsequently, a bias voltage is applied to the storage unit by using a voltage control line connected to the to-be-written storage unit. In this way, the to-be-written storage unit is selected. Then, data is written to the to-be-written storage unit based on the write voltage and the bias voltage.

A fourth aspect of the embodiments of this application provides a data read method for a random access memory, including:
the magnetic random access memory includes a plurality of structural units, a plurality of voltage control lines, a plurality of first bit lines, a plurality of second bit lines, and a plurality of word lines, where the voltage control lines are parallel to the second bit lines, the first bit lines are parallel to the word lines, the voltage control lines are perpendicular to the first bit lines, planes on which the plurality of structural units are located are parallel to each other, each structural unit includes a plurality of storage strings parallel to each other, each storage string includes a plurality of layers of storage structure that are sequentially stacked and a transistor, each layer of storage structure includes a spin-orbit torque SOT electrode line and a storage unit disposed on the SOT electrode line, the storage unit may be a magnetic tunnel junction, one terminal thereof is connected to the voltage control line, the other terminal thereof is connected to the SOT electrode line, the SOT electrode line and the voltage control line are perpendicular to each other, all SOT electrode lines in each storage string are connected in series by using metal wires, one first bit line and one word line are shared in each structural unit, first terminals of all storage strings in each structural unit are connected to a same first bit line, gates of transistors in all storage strings are connected to a same word line, a second terminal of the storage string is connected to a first terminal of the transistor, and a second terminal of the transistor is connected to the second bit line.

When data is read from the random access memory, first, a target structural unit corresponding to a to-be-read storage string needs to be determined. Next, a gate bias voltage is applied to a transistor in the to-be-read storage string by using a word line corresponding to the target structural unit, so that all storage strings in the target structural unit are turned on. Then, a read voltage is applied to both a voltage control line and a first bit line. Finally, a second bit line correspondingly connected to the transistor in the to-be-read storage string is grounded, a read voltage is applied to another second bit line, and then data corresponding to the to-be-read storage string is determined based on a read current.

A fifth aspect of the embodiments of this application provides an electronic device, where the electronic device includes a processor and the magnetic random access memory that is coupled to the processor and that is provided in any one of the first aspect or the possible designs of the first aspect.

Specifically, the processor may invoke a software program stored in the magnetic random access memory to perform a corresponding method and implement a corresponding function of the electronic device.

### BRIEF DESCRIPTION OF DRAWINGS

FIG. 1 is a block diagram of a structure of a magnetic random access memory according to an embodiment of this application;
FIG. 2 is a schematic diagram of a structure of a magnetic random access memory according to an embodiment of this application;
FIG. 3 is a schematic diagram of connecting storage strings according to an embodiment of this application;
FIG. 4 is another schematic diagram of connecting storage strings according to an embodiment of this application;
FIG. 5 is a schematic diagram of a structure of another magnetic random access memory according to an embodiment of this application;
FIG. 6 is a schematic diagram of a structure of an MTJ according to an embodiment of this application; and
FIG. 7 is a block diagram of a structure of an electronic device according to an embodiment of this application.

### DESCRIPTION OF EMBODIMENTS

The following clearly and completely describes the technical solutions in embodiments of this application with reference to the accompanying drawings in embodiments of this application.

Embodiments of this application provide a magnetic random access memory and an electronic device, to improve a storage density of the magnetic random access memory and improve stability of a storage unit.

The following briefly describes an application scenario in the embodiments of this application.

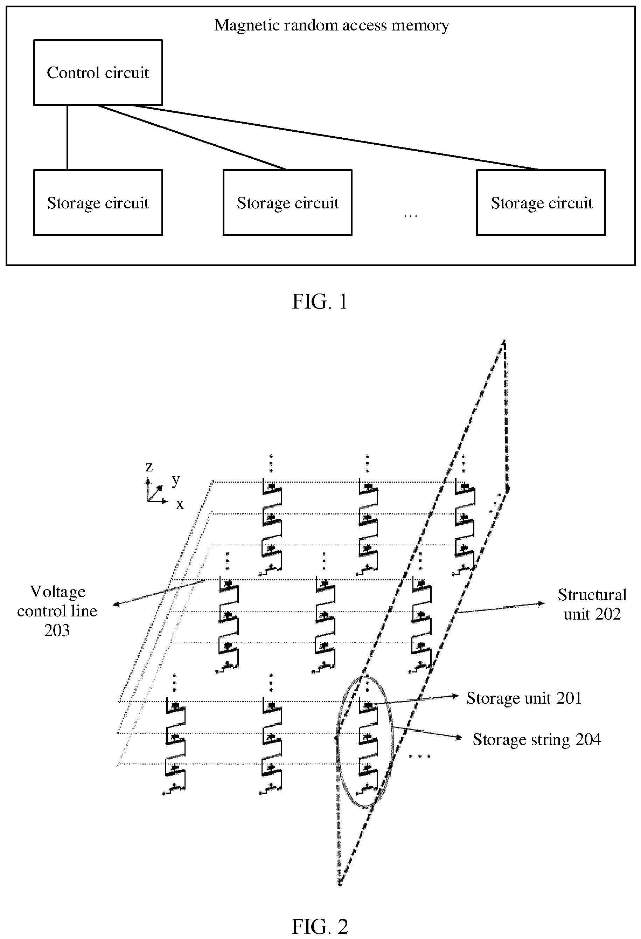

The embodiments of this application may be applied to a magnetic random access memory shown in FIG. 1. The magnetic random access memory includes a control circuit and at least one storage circuit.

Specifically, each storage circuit is configured to write and read data. The control circuit is configured to control a process in which the storage circuit writes and reads data. For example, when data is written, a storage unit to which data is to be written is selected, so that data is written to the selected storage unit by applying a corresponding voltage and a corresponding current. For another example, when data is read, a storage unit from which data is to be read is selected, so that data is read from the selected storage unit by applying a corresponding voltage and a corresponding current.

Each storage circuit includes a plurality of storage units. The storage unit is a smallest unit that has a data storage and read/write function in the magnetic random access memory, and may be configured to store information in a smallest unit, namely, 1-bit data (for example, 0 or 1), namely, a binary digit.

The following further describes in detail embodiments of this application with reference to the accompanying drawings.

It should be noted that "a plurality of" in this application means "two or more". In addition, it should be understood that in description of this application, terms such as "first" and "second" are merely used for distinguishing and description, but should not be understood as indicating or implying relative importance, or should not be understood as indicating or implying a sequence.

FIG. 2 is a schematic diagram of a structure of a magnetic random access memory according to an embodiment of this application. The random access memory includes a plurality of storage units 201 that are sequentially stacked in three-dimensional space, and includes a plurality of structural units 202 and a plurality of voltage control lines 203. The plurality of structural units 202 and the plurality of voltage control lines 203 may be considered as the storage circuit in FIG. 1.

Each structural unit 202 includes a plurality of storage strings 204, and the plurality of storage strings 204 are parallel to each other. Each storage string 204 includes a plurality of layers of storage structure that are sequentially stacked. Each layer of storage structure includes a spin-orbit torque SOT electrode line perpendicular to the voltage control line 203 and a storage unit 201 disposed on the SOT electrode line. The storage unit 201 is a magnetic tunnel junction, and one terminal of the magnetic tunnel junction is connected to the SOT electrode line at the layer. All SOT electrode lines in one storage string are connected in series by using metal wires.

In the magnetic random access memory, the voltage control lines 203 are in a one-to-one correspondence with the storage units 201, that is, each storage unit 201 has a corresponding voltage control line 203, to apply a voltage to the storage unit 201.

Optionally, the plurality of voltage control lines 203 are parallel to each other. Planes on which the plurality of structural units 202 are located are parallel to each other, and a plane on which each structural unit 202 is located is perpendicular to a plurality of voltage control lines 203.

It should be noted that, in this embodiment of this application, a concept that the plurality of voltage control lines 203 are parallel to each other is not a concept that the plurality of voltage control lines 203 are strictly parallel to each other. In a process of producing the magnetic random access memory, the plurality of voltage control lines 203 may not be strictly parallel to each other due to an impact of a production technology and a production device. This case is caused by a specific production procedure, and does not indicate that the case in which the plurality of voltage control lines 203 are not strictly parallel to each other departs from the protection range of this application. In addition, two location relationships, for example, the planes are parallel and perpendicular, are also understood similarly. Details are not described herein again.

For ease of description, an xyz coordinate system is shown for the magnetic random access memory shown in FIG. 2. In the magnetic random access memory, the voltage control lines 203 are arranged in parallel along the x-axis. The plane on which each structural unit 202 is located is perpendicular to the x-axis. In each storage string 204, the plurality of layers of storage structures are sequentially stacked in a direction of the z-axis, and electrode lines corresponding to each layer of storage structures are arranged along the y-axis, and may be perpendicular to the voltage control line 203.

It should be understood that the storage unit 201 is a smallest unit that has a data storage and read/write function in the magnetic random access memory, and may be configured to store a smallest information unit, namely, 1-bit data (for example, 0 or 1), namely, a binary digit. A plurality of pieces of binary-digit data may be stored by using the plurality of storage units 201. Specifically, in this embodiment of this application, one storage unit 201 includes one MTJ, configured to store one binary digit. Each MTJ may include a free layer, a tunnel layer, and a pinning layer that are sequentially stacked in a positive direction of the z-axis. A magnetic moment direction of the pinning layer is fixed. A magnetic moment direction of the free layer may be changed when data is written. When magnetic moments of the free layer and the pinning layer are arranged in a parallel or antiparallel manner, the storage unit corresponds to different data. The tunnel layer is used to generate a tunnel magnetoresistance effect. Specifically, in this application, the free layer is connected to the electrode line, and the pinning layer is connected to the voltage control line. In other words, the free layer is close to an electrode line connected to the MTJ, the pinning layer is farthest from the electrode line, and the tunnel layer is located between the free layer and the reference layer.

Specifically, in this embodiment of this application, that magnetic moment directions of the free layer and the pinning layer are arranged in a parallel or antiparallel manner may be understood as follows: The magnetic moment directions of the free layer and the pinning layer may be on an xy plane, may be perpendicular to an xy plane, or may be inclined to an xy plane at a specified angle. In this embodiment of this application, the magnetic moment directions of the free layer and the pinning layer are not specifically limited, provided that the magnetic moment directions of the free layer and the pinning layer are arranged in a parallel or antiparallel manner.

Specifically, in each storage string 204, all SOT electrode lines are connected in series by using metal wires. There may be a plurality of connection manners. No limitation is specifically imposed. For example, the following two serial connection manners may be included:

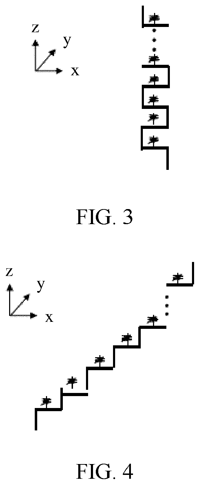

FIG. 3 is a schematic diagram of connecting storage strings 204 in series according to an embodiment of this application. In one storage string 204, a plurality of storage units 201 are sequentially stacked in the direction of the z-axis, each storage unit 201 includes a magnetic tunnel junction, and the magnetic tunnel junction is disposed on one SOT electrode line. When SOT electrode lines that are sequentially stacked are connected in series by using metal wires, a first terminal of an SOT electrode line of an N^{th} layer of storage structure may be connected to a first terminal of an SOT electrode line of an (N+1)^{th} layer of storage structure, and then a second terminal of the SOT electrode line of the (N+1)^{th} layer of storage structure is connected to a second terminal of an SOT electrode line of an (N+2)^{th} layer of storage structure. For example, as shown in FIG. 3, the SOT electrode line may have a left terminal and a right terminal. To be specific, a left terminal of the first layer is connected to a left terminal of the second layer, a right terminal of the second layer is connected to a right terminal of the third layer, a left terminal of the third layer is connected to a left terminal of the fourth layer, and the plurality of layers of SOT electrode lines are sequentially connected based on the sequence. It may be understood that, when a current is applied to the SOT electrode line in the storage string by using the metal wire, current flow directions in SOT electrode lines corresponding to two adjacent layers of magnetic tunnel junctions are different.

FIG. 4 is another schematic diagram of connecting storage strings 204 according to an embodiment of this application. In one storage string 204, a plurality of storage units 201 are still sequentially stacked in the direction of the z-axis. The storage units 201 in the storage string 204 may be sequentially arranged in the positive direction of the Z-axis, or may be staggered from each other. When SOT electrode lines that are sequentially stacked are connected in series by using metal wires, a first terminal of an SOT electrode line of an N^{th} layer of storage structure may be connected to a second terminal of an SOT electrode line of an (N+1)^{th} layer of storage structure. For example, as shown in FIG. 3B, a right terminal of the first layer of SOT electrode line is connected to a left terminal of the second layer of SOT electrode line, a right terminal of the second layer of SOT electrode line is connected to a left terminal of the third layer of SOT electrode line, and the SOT electrode lines are sequentially connected in a head-to-tail manner. It may be understood that, when a current is applied to the SOT electrode line in the storage string by using the metal wire, current flow directions in SOT electrode lines corresponding to all layers of magnetic tunnel junctions are the same.

The following describes, based on the structural framework shown in FIG. 2, how to control the storage unit 201, and how to write data to the storage unit 201 or read data stored in the storage unit 201.

In the magnetic random access memory, a specific storage unit 201 is selected based on different bit lines to write or read data. In the schematic diagram of the structure shown in FIG. 2, each storage string 204 may be further connected in series with a transistor, configured to control the storage string 204 to be turned on and turned off. For example, the transistor may be directly connected to an SOT electrode line corresponding to a first layer of storage structure in the storage string 204, or may be connected to an SOT electrode line corresponding to an uppermost layer of storage structure in the storage string 204. The SOT electrode line may be connected to a source of the transistor, or may be connected to a drain of the transistor. No limitation is specifically imposed.

The magnetic random access memory further includes a plurality of different bit lines. A manner in which the plurality of storage strings 204 are connected to the bit lines is as follows: In the direction of the z-axis, an uppermost terminal of the storage string 204 is connected to a first bit line, and the transistor at a lower terminal of the storage string 204 is connected to a second bit line. To be specific, different voltages may be applied to the first bit line and the second bit line to provide a current for all SOT electrode lines in one storage string 204. A gate of the transistor is connected to a word line, and a gate bias voltage may be applied to the gate of the transistor by using the word line, to control the transistor in the storage string 204 to be turned on and turned off.

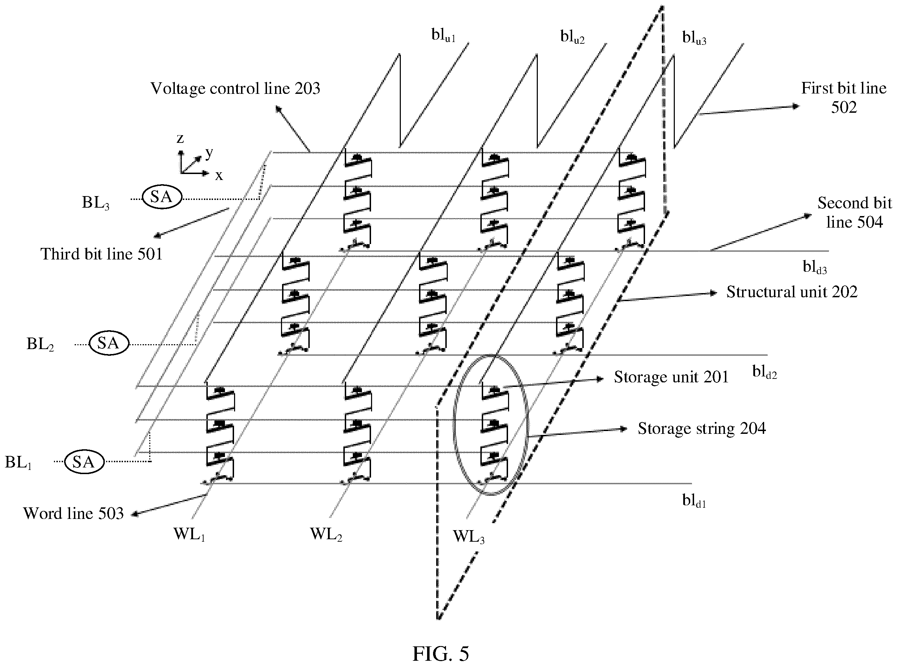

For example, as shown in FIG. 5, in the magnetic random access memory, a plurality of voltage control lines 203 are parallel to the x-axis, and a same layer of storage units 201 in one row of storage strings 204 that are sequentially arranged in the direction of the x-axis are correspondingly connected to one voltage control line 203. A third bit line 501 is connected to all voltage control lines 203 corresponding to an entire layer of storage structures, that is, when a voltage is applied by using one third bit line 501, a voltage is applied to voltage control lines 203 corresponding to an entire layer of storage units 201.

A plurality of first bit lines 502 are parallel to the y-axis. Storage strings 204 in each structural unit 202 are connected to a same first bit line 502. A plurality of word lines 503 are also parallel to the y-axis. Gates of transistors in the storage strings 204 in each structural unit 202 are connected to a same word line 503, that is, when a gate bias voltage is applied by using one word line 503, all transistors in one structural unit 202 are turned on.

A plurality of second bit lines 504 are parallel to the voltage control lines 203, and are perpendicular to planes on which the structural units 202 are located. Gates/drains of transistors in one row of storage strings 204 that are sequentially arranged in the direction of the x-axis are correspondingly connected to one second bit line 504.

In addition, it should be noted that, in the magnetic random access memory shown in FIG. 4, for ease of illustration, only three storage strings 204 that are sequentially arranged in the direction of the x-axis and three storage strings 204 that are sequentially arranged in the direction of the y-axis are shown. Therefore, the first bit lines include *bl*_{*u*1}, *bl*_{*u*2}, and *bl*_{*u*3}, the second bit lines successively include *bl*_{*d*1}, *bl*_{*d*2}, and *bl*_{*d*3}. The word lines include *WL*₁*, WL*₂, and *WL*₃. The third bit lines include *BL*₁, *BL*₂, and *BL*₃. In the magnetic random access memory, a plurality of storage strings 204 may be arranged in any direction, and a quantity thereof is not limited.

### (1) Data is written to the magnetic random access memory.

In the magnetic random access memory provided in this embodiment of this application, an SOT effect and a VCMA effect are used when data is written, and a tunnel magnetoresistance (tunnel magnetoresistance, TMR) effect is used when data is read.

A principle of the SOT effect is as follows: When a current is applied to the electrode line, a spin polarized current that is diffused upward (namely, in the positive direction of the z-axis) is generated, and enters the free layer of the MTJ. When the current reaches a value (critical turn current density), the magnetic moment of the free layer is reversed under an action of spin-orbit torque, to write data. A direction of the current in the electrode line is changed, a polarization direction of the spin current is changed, and the magnetic moment reversal direction of the free layer is also changed, to write different data. A principle of the VCMA effect is as follows: When a bias voltage is applied to two terminals of the MTJ, interface charge densities of the free layer and the tunnel layer of the MTJ may be changed, to change perpendicular magnetic anisotropy and coercivity of the free layer, so as to reduce the critical turn current density of the MTJ. When the critical turn current density of the MTJ is reduced by using the VCMA effect, a current is applied to the electrode line, and the magnetic moment of the free layer is reversed under an action of both the SOT effect and the VCMA effect, to write data. This write manner can significantly reduce power consumption of writing data.

In actual application, the electrode line may be made of a heavy metal material, or may be made of another material that can generate a spin current, and the electrode line may also be referred to as the SOT electrode line.

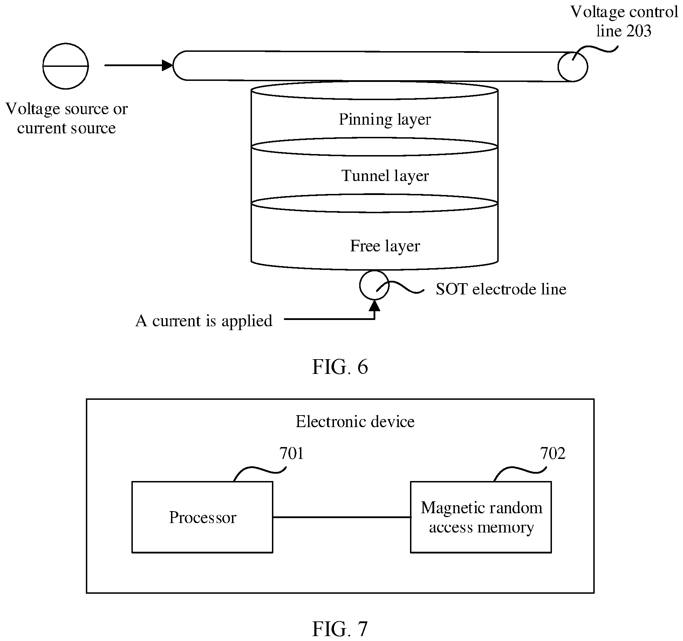

For example, the structure of the MTJ in the magnetic random access memory shown in FIG. 2 may be shown in FIG. 6. It may be learned from FIG. 6 that the free layer of the MTJ is connected to the electrode line, and the pinning layer of the MTJ is connected to the voltage control line 203. A voltage or a current is applied to the voltage control line 203 by using a voltage source or a current source, and a current is applied to the SOT electrode line, so that a voltage difference can exist between a voltage on the voltage control line 203 and a voltage on the SOT electrode line. The voltage difference is the bias voltage applied to two terminals of the MTJ.

Specifically, in this embodiment of this application, when data is written to the magnetic random access memory, the voltage control line 203 is used to independently perform a selective operation on the MTJ connected to the voltage control line 203. For example, a first bias voltage may be applied to a voltage control line 203 connected to a to-be-written storage unit, to reduce a critical turn current density of the to-be-written storage unit. A second bias voltage is applied to a voltage control line 203 connected to a non-write storage unit, to improve (or not to change) a critical turn current density of the non-write storage unit. In addition, a write current (when currents in different directions are applied, different data may be written) is applied to an electrode line connected to the to-be-written storage unit, so that a spin current that is diffused upward (namely, in the positive direction of the z-axis) is generated, and enters the free layer of the MTJ, to write data to the to-be-written storage unit.

A principle of the TMR effect is as follows: When the magnetic moments of the free layer and the pinning layer of the MTJ are arranged in a parallel manner, the MTJ is in a low resistance state. When the magnetic moments of the free layer and the pinning layer are arranged in an antiparallel manner (that is, the magnetic moments are parallel but opposite in directions), the MTJ is in a high resistance state. The high resistance and the low resistance represent two different data states, for example, 0 or 1. Different data may be read based on whether the MTJ is in a high resistance state or a low resistance state.

Specifically, in this embodiment of this application, when data is read from the magnetic random access memory, an electrode line connected to a to-be-read storage unit is used to provide a ground circuit for the storage unit 201. A read voltage or a read current is applied to a voltage control line 203 connected to the to-be-read storage unit, and data information carried by the to-be-read storage unit is obtained by using a read circuit (for example, an amplifier SA on a third bit line) connected to the voltage control line 203.

For example, a read current in the read circuit is compared with a reference current by using the amplifier, so that it can be determined whether an MTJ corresponding to a voltage control line 203 connected to the amplifier is in a high resistance state or a low resistance state, to determine whether data stored in the MTJ is 0 or 1.

When data is written, a current on the electrode line flows through the MTJ to form a sneak path (sneak path), to affect accuracy of writing data. To avoid the case, in this embodiment of this application, the MTJ may have a high resistance characteristic, for example, a resistance value of the MTJ is not less than 100 KΩ, so that the resistance value of the MTJ is far greater than a resistance value of the electrode line. In this way, a write current can be effectively prevented from flowing through the MTJ, to reduce an impact of the sneak path.

In addition, in the magnetic random access memory shown in FIG. 2, the magnetic moment directions of the free layer and the pinning layer are arranged in a parallel or antiparallel manner. Specifically, the magnetic moment directions of the free layer and the pinning layer may be on the xy plane, may be perpendicular to the xy plane, or may be inclined to the xy plane at a specified angle. In this embodiment of this application, the magnetic moment directions of the free layer and the pinning layer are not specifically limited, provided that the magnetic moment directions of the free layer and the pinning layer are arranged in a parallel or antiparallel manner.

Based on the foregoing structural framework of the magnetic random access memory, when data is written to the storage unit 201, a process of applying a current to the SOT electrode line may be controlled by using the first bit line 502 and the second bit line 504. The first bit line 502 is directly connected to an upper terminal of the storage string 204, and the second bit line 504 is connected to a terminal of the transistor in the storage string 204. The second bit line 504 may be connected to the source of the transistor, or may be connected to the drain of the transistor. No specific limitation is imposed. Turn-on and turn-off of the transistor are controlled by using the word line 503. A gate bias voltage is applied to the transistor by using the corresponding word line 503, so that the transistor is turned on. In addition, different voltages are applied to the first bit line 502 and the second bit line 504 that correspond to the storage string 204, so that a target storage string can be selected, to apply a write current to SOT electrode lines in the target storage string.

Specifically, in the magnetic random access memory shown in FIG. 5, when data is written to a to-be-written storage unit, first, a structural unit 202 to which the to-be-written storage unit belongs is determined. Next, a gate bias voltage is applied by using a word line 503 corresponding to the structural unit 202. In this way, transistors in all storage strings 204 in one structural unit 202 are turned on. Optionally, no gate bias voltage is applied to a remaining word line 503. This is equivalent to selecting the structural unit 202 in which the to-be-written storage unit is located.

It may be understood that, in a manner, a write voltage may be applied by using a first bit line 502 corresponding to the structural unit 202. Then, a second bit line 504 corresponding to a storage string 204 in which the to-be-written storage unit is located is determined, and the second bit line 504 is grounded. A write voltage is applied to a remaining second bit line 504. In this way, the storage string 204 in which the to-be-written storage unit is located is a unique storage string with one terminal to which the write voltage is applied and the other terminal that is grounded, that is, a write current exists on SOT electrode lines in the storage string 204. This is equivalent to selecting the storage string in which the to-be-written storage unit is located.

After the storage string 204 in which the to-be-written storage unit is located is selected, a bias voltage may be applied to all layers of voltage control lines 203 by using a plurality of third bit lines 501. Optionally, a third bit line 501 corresponding to the to-be-written storage unit is first determined, then a first bias voltage is applied to the third bit line 501, and a second bias voltage is applied to another third bit line 501. The first bias voltage is not equal to the second bias voltage.

The first bias voltage is used to reduce a critical turn current density of the to-be-written storage unit, and the second bias voltage is used to improve (or not to change) a critical turn current density of a non-write storage unit. Values of the first bias voltage and the second bias voltage are different. Specific values of the first bias voltage and the second bias voltage may be determined based on a specific structure and a material parameter of the storage unit 201. In other words, when the first bias voltage is applied to the voltage control line 203, data may be written to the storage unit 201 connected to the voltage control line 203. When the second bias voltage is applied to the voltage control line 203, data cannot be written to the storage unit 201 connected to the voltage control line 203.

In a specific example, a difference between the first bias voltage and a voltage of the electrode line is a negative value, and a difference between the second bias voltage and the voltage of the electrode line is a positive value or zero. Alternatively, a difference between the first bias voltage and a voltage of the electrode line is a positive value, and a difference between the second bias voltage and the voltage of the electrode line is a negative value or zero.

The to-be-written storage unit completes data write by using the applied write current and first bias voltage.

It may be understood that, in another manner, a first bit line 502 corresponding to the structural unit 202 may be grounded. Then, a second bit line 504 corresponding to a storage string 204 in which the to-be-written storage unit is located is determined, and a write voltage is applied by using the second bit line 504. Optionally, a remaining second bit line 504 may be grounded. In this way, it may also be ensured that the storage string 204 in which the to-be-written storage unit is located is a unique storage string with one terminal to which the write voltage is applied and the other terminal that is grounded, that is, a reverse write current exists on SOT electrode lines in the storage string 204. This is equivalent to selecting the storage string in which the to-be-written storage unit is located. Subsequently, a third bit line 501 corresponding to the to-be-written storage unit 201 is determined, and a first bias voltage is applied to the third bit line 501 to complete writing of different data.

Because the SOT electrode lines in the storage string are connected in series in a plurality of manners, if the SOT electrode lines in the storage string 204 are connected in series in the manner shown in FIG. 3, it may be learned that, when a write voltage is provided for the storage string 204 by using the first bit line 502 and the second bit line 504, flow directions of write currents in SOT electrode lines corresponding to two adjacent layers of storage units are different. Therefore, if same data is written to two adjacent layers of storage units, control manners thereof are also different. For example, if data " 1" needs to be written to the first layer of storage unit, a write voltage may be applied by using the first bit line, and the second bit line is grounded. If data " 1" needs to be written to the second layer of storage unit, a write voltage may be applied by using the second bit line, and the first bit line is grounded.

In actual application, when data is written to the magnetic random access memory, the foregoing process of applying a voltage or a current to the first bit line 502, the second bit line 504, the word line 503, and the voltage control line 203 may be controlled by a level control circuit configured in the magnetic random access memory. The level control circuit is configured to provide a required voltage or current for the first bit line 502, the second bit line 504, the word line 503, and the voltage control line 203. Similarly, when data is read from the magnetic random access memory, a process of applying a voltage or a current to the voltage control line 203 may also be controlled by the level control circuit, and the level control circuit is configured to provide a required voltage or current for the voltage control line 203.

In addition, the magnetic random access memory may further include a row address decoding circuit and a column address decoding circuit, configured to select, when data is written or read, a corresponding storage unit by using a word line and a bit line. The level control circuit may determine, based on the selection of the row address decoding circuit and the column address decoding circuit, a voltage or a current that needs to be applied to the first bit line, the second bit line, and the word line, to implement a read/write operation on one or several storage units selected by the row address decoding circuit and the column address decoding circuit.

The level control circuit, the row address decoding circuit, and the column address decoding circuit may be collectively referred to as a control circuit.

### (2) Data is read from the magnetic random access memory.

When data is read from the magnetic random access memory, data stored in all storage units in a storage string may be read at one time.

The TMR effect is used to read the data in the storage unit. When data is read from the magnetic random access memory, a gate bias voltage is separately applied to the transistor by using the word line, so that the transistor is turned on. Each of the plurality of voltage control lines is used to: apply a read voltage or a read current to a storage unit correspondingly connected to the voltage control line, and receive feedback information of the storage unit correspondingly connected to the voltage control line. The feedback information is used to indicate data stored in the storage unit correspondingly connected to the voltage control line.

When each voltage control line is used to apply a read voltage to the storage unit correspondingly connected to the voltage control line, the feedback information of the storage unit may be information such as a current and a capacitance of the storage unit. When read voltages applied by using all voltage control lines are the same, and storage units are in different resistance states, feedback currents or capacitances are different. When each voltage control line is used to apply a read current to the storage unit correspondingly connected to the voltage control line, the feedback information of the storage unit may be information such as a voltage and a capacitance of the storage unit. When read currents applied by using all voltage control lines are the same, and storage units are in different resistance states, feedback voltages or capacitances are different.

In addition, the magnetic random access memory may further include a plurality of amplifiers that are connected to the plurality of third bit lines in a one-to-one correspondence manner, and each of the plurality of amplifiers is configured to read feedback information received by a voltage control line correspondingly connected to the amplifier.

Each amplifier, a peripheral circuit thereof, and the like together form a read circuit used to receive feedback information of a storage unit corresponding to a voltage control line connected to the amplifier, to read data in the storage unit.

Specifically, each amplifier may compare the feedback information (such as a voltage, a current, a capacitance, and a charge/discharge time) of the storage unit with a reference value, to determine whether the storage unit is in a high resistance state or a low resistance state, so as to determine data stored in the storage unit.

When data is read from the magnetic random access memory, data in all storage units 201 in one storage string 204 is read at one time. An example is as follows: First, a word line 503 corresponding to a structural unit 202 to which a to-be-read storage string belongs needs to be determined. Next, a gate bias voltage is applied to a transistor in the to-be-read storage string by using the word line 503, so that the transistor in the storage string 204 is turned on. This is equivalent to selecting the structural unit in which the storage string 204 is located. A read voltage is applied to all first bit lines 402 and all third bit lines 501, and a second bit line 504 corresponding to the to-be-read storage string is grounded. In addition, a read voltage needs to be applied to all other second bit lines 504. In this way, it is ensured that a voltage difference exists only between two terminals of an MTJ of the storage unit in the to-be-read storage string. This is equivalent to selecting the to-be-read storage string. Finally, feedback information received by amplifiers in a one-to-one correspondence with the third bit lines is used to determine a high/low resistance state corresponding to each layer of storage unit in the to-be-read storage string, so that data in the entire storage string is read.

According to the magnetic random access memory provided in this embodiment of this application, each storage string includes a plurality of layers of storage structures, so that 3D stacking of the storage structures can be implemented, to improve a storage density of the magnetic random access memory. According to the magnetic random access memory provided in this embodiment of this application, data may be written to the storage unit by using the SOT effect and the VCMA effect, that is, a bias voltage is applied to the voltage control line connected to the magnetic tunnel junction, and the critical turn current density of the magnetic tunnel junction is changed by using the VCMA effect. In addition, a current is applied to the electrode line connected to the magnetic tunnel junction, and the magnetic moment of the free layer is reversed by using the SOT effect, to write data.

Based on a same invention concept, an embodiment of this application further provides a data write method for a magnetic random access memory, including:
determining a structural unit to which a to-be-written storage unit belongs, where the magnetic random access memory includes a plurality of structural units, planes on which the plurality of structural units are located are parallel to each other, each of the plurality of structural units includes a plurality of storage strings parallel to each other, each of the plurality of storage strings includes a plurality of layers of storage structures that are sequentially stacked, each of the plurality of layers of storage structures includes a spin-orbit torque SOT electrode line and a storage unit disposed on the SOT electrode line, the storage unit includes a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying, by using a word line corresponding to the structural unit, a gate bias voltage to a transistor in a storage string to which the to-be-written storage unit belongs, and applying a write voltage to the storage unit by using a first bit line corresponding to the structural unit, where the structural unit includes a word line and a first bit line, both the word line and the first bit line are perpendicular to the voltage control line, and the plurality of storage strings in each structural unit are separately connected to the word line and the first bit line;
grounding a second bit line corresponding to the storage string to which the to-be-written storage unit belongs, where the second bit line is parallel to the voltage control line, and the second bit line is connected to the transistor in the storage string;
applying a bias voltage to the storage unit by using a voltage control line connected to the to-be-written storage unit; and
writing data to the to-be-written storage unit based on the write voltage and the bias voltage.

Based on a same invention concept, an embodiment of this application further provides another data write method for a magnetic random access memory, including:
determining a structural unit to which a to-be-written storage unit belongs, where the magnetic random access memory includes a plurality of structural units, planes on which the plurality of structural units are located are parallel to each other, each of the plurality of structural units includes a plurality of storage strings parallel to each other, each of the plurality of storage strings includes a plurality of layers of storage structures that are sequentially stacked, each of the plurality of layers of storage structures includes a spin-orbit torque SOT electrode line and a storage unit disposed on the SOT electrode line, the storage unit includes a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying, by using a word line corresponding to the structural unit, a gate bias voltage to a transistor in a storage string to which the to-be-written storage unit belongs, and grounding a first bit line corresponding to the structural unit, where the structural unit includes a word line and a first bit line, both the word line and the first bit line are perpendicular to the voltage control line, and the plurality of storage strings in each structural unit are separately connected to the word line and the first bit line;
applying a write voltage to the to-be-written storage unit by using a second bit line corresponding to the storage string to which the to-be-written storage unit belongs, where the second bit line is parallel to the voltage control line, and the second bit line is connected to the transistor in the storage string;
applying a bias voltage to the storage unit by using a voltage control line connected to the to-be-written storage unit; and
writing data to the to-be-written storage unit based on the write voltage and the bias voltage.

Based on a same invention concept, an embodiment of this application further provides a data read method for a magnetic random access memory, including:
determining a target structural unit corresponding to a to-be-read storage string, where the magnetic random access memory includes a plurality of structural units, planes on which the plurality of structural units are located are parallel to each other, each of the plurality of structural units includes a plurality of storage strings parallel to each other, each of the plurality of storage strings includes a plurality of layers of storage structures that are sequentially stacked, each of the plurality of layers of storage structures includes a spin-orbit torque SOT electrode line and a storage unit disposed on the SOT electrode line, the storage unit includes a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying a gate bias voltage to a transistor in the to-be-read storage string by using a word line corresponding to the target structural unit, where each structural unit includes a word line and a first bit line, both the word line and the first bit line are perpendicular to the voltage control line, and the plurality of storage strings in each structural unit are separately connected to the word line and the first bit line;
applying a read voltage to both the voltage control line and the first bit line;
grounding a second bit line corresponding to the transistor in the to-be-read storage string, where another second bit line is used to apply a read voltage, the second bit line is parallel to the voltage control line, and the second bit line is connected to the transistor in the storage string; and
determining, based on a read voltage or current received on a third bit line, data corresponding to the to-be-read storage string.

Based on a same invention concept, an embodiment of this application further provides an electronic device. Referring to FIG. 7, the electronic device includes a processor 701 and a magnetic random access memory 702 coupled to the processor. The magnetic random access memory 702 may be the magnetic random access memory shown in FIG. 5.

Specifically, the processor 701 may invoke a software program stored in the magnetic random access memory 702 to perform a corresponding method and implement a corresponding function of the electronic device.

Clearly, persons skilled in the art can make various modifications and variations to embodiments of this application without departing from the spirit and scope of embodiments of this application. In this case, this application is intended to cover these modifications and variations provided that they fall within the scope of protection defined by the following claims and their equivalent technologies.

## Claims

1. A magnetic random access memory, comprising a plurality of structural units and a plurality of voltage control lines, wherein the plurality of voltage control lines are parallel, planes on which the plurality of structural units are located are parallel, and a plane on which each of the plurality of structural units is located is perpendicular to the plurality of voltage control lines;
each of the plurality of structural units comprises a plurality of storage strings parallel to each other, each of the plurality of storage strings comprises a plurality of layers of storage structures that are sequentially stacked, each layer of storage structure of the plurality of layers of storage structures comprises a spin-orbit torque SOT electrode line perpendicular to the plurality of voltage control lines and a storage unit disposed on the SOT electrode line; and the storage unit comprises a magnetic tunnel junction, one terminal of the storage unit is connected to one of the plurality of voltage control lines, the other terminal of the storage unit is connected to the SOT electrode line, and all SOT electrode lines in each storage string are connected in series by using metal wires.

2. The magnetic random access memory according to claim 1, wherein the magnetic random access memory further comprises a plurality of first bit lines and a plurality of word lines, and the plurality of first bit lines are parallel to the plurality of word lines, and are perpendicular to the plurality of voltage control lines; and
each of the plurality of storage strings further comprises a transistor, and a first terminal of the storage string is connected to a first terminal of the transistor, wherein second terminals of all storage strings belonging to a same structural unit are connected to a same first bit line in the plurality of first bit lines, and gates of all transistors belonging to a same structural unit are connected to a same word line in the plurality of word lines.

3. The magnetic random access memory according to claim 2, wherein the magnetic random access memory further comprises a plurality of second bit lines; the plurality of second bit lines are parallel to the plurality of voltage control lines; and a second terminal of the transistor is connected to one second bit line in the plurality of second bit lines.

4. The magnetic random access memory according to claims 1 to 3, wherein the magnetic random access memory further comprises a plurality of third bit lines, and each of the plurality of third bit lines is used to connect and control, by using metal wires, voltage control lines corresponding to one layer of storage structures of the plurality of layers of storage structures.

5. The magnetic random access memory according to claims 1 to 4, wherein in each of the plurality of storage strings, the SOT electrode lines are sequentially stacked; a first terminal of an SOT electrode line of an N^{th} layer of storage structure of the plurality of layers of storage structures is connected to a first terminal of an SOT electrode line of an (N+1)^{th} layer storage structure of the plurality of layers of storage structures by using a metal wire, and a second terminal of the SOT electrode line of the (N+1)^{th} layer of storage structure is connected to a second terminal of an SOT electrode line of an (N+2)^{th} layer of storage structure of the plurality of layers of storage structures.

6. The magnetic random access memory according to claims 1 to 4, wherein in each of the plurality of storage strings, the SOT electrode lines are sequentially stacked; and a first terminal of a SOT electrode line of the Nth layer of storage structure of the plurality of layers of storage structures is connected to a second terminal of a SOT electrode line of an (N+1)^{th} layer of storage structure of the plurality of layers of storage structures by using a metal wire.

7. The magnetic random access memory according to claim 5 or 6, wherein when data is written to the magnetic random access memory, the word line corresponding to the structural unit to which the to-be-written storage unit belongs is used to apply a gate bias voltage to the transistor in the storage string to which the to-be-written storage unit belongs; the first bit line connected to the storage string to which the to-be-written storage unit belongs is used to apply a write voltage, and the second bit line connected to the storage string to which the to-be-written storage unit belongs is grounded; and the third bit line that is correspondingly connected to the voltage control line connected to the to-be-written storage unit is used to apply a bias voltage.

8. The magnetic random access memory according to claim 5 or 6, wherein when data is written to the magnetic random access memory, the word line corresponding to the structural unit to which the to-be-written storage unit belongs is used to apply a gate bias voltage to the transistor in the storage string to which the to-be-written storage unit belongs; the first bit line connected to the storage string to which the to-be-written storage unit belongs is grounded, and the second bit line connected to the storage string to which the to-be-written storage unit belongs is used to apply a write voltage; the third bit line that is correspondingly connected to the voltage control line connected to the to-be-written storage unit is used to apply a bias voltage.

9. The magnetic random access memory according to claim 6, 7, or 8, wherein when data is read from the magnetic random access memory, the word line corresponding to the structural unit to which the to-be-read storage string belongs is used to apply a gate bias voltage to the transistor in the to-be-read storage string; and the plurality of third bit lines and the plurality of first bit lines in the magnetic random access memory are configured to apply a read voltage; and the second bit line correspondingly connected to the transistor in the to-be-read storage string is grounded, and another second bit line is used to apply a read voltage.

10. The magnetic random access memory according to any one of claims 1 to 9, wherein each magnetic tunnel junction comprises a free layer, a barrier layer, and a reference layer that are sequentially stacked, the free layer is connected to the SOT electrode line, and the reference layer is connected to the voltage control line.

11. The magnetic random access memory according to claim 4, wherein the magnetic random access memory further comprises a plurality of amplifiers SAs; and
the plurality of amplifiers SA are connected to the plurality of third bit lines in a one-to-one correspondence, and each amplifier in the plurality of amplifiers is used to read a signal received by a correspondingly connected third bit line.

12. A data write method for a magnetic random access memory, wherein the method comprises:
determining a structural unit to which a to-be-written storage unit belongs, wherein the magnetic random access memory comprises a plurality of structural units, planes on which the plurality of structural units are located are parallel to each other, each of the plurality of structural units comprises a plurality of storage strings parallel to each other, each of the plurality of storage strings comprises a plurality of layers of storage structures that are sequentially stacked, each of the plurality of layers of storage structures comprises a spin-orbit torque SOT electrode line and a storage unit disposed on the SOT electrode line, the storage unit comprises a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying, by using a word line corresponding to the structural unit, a gate bias voltage to a transistor in a storage string to which the to-be-written storage unit belongs, and applying a write voltage to the storage unit by using a first bit line corresponding to the structural unit, wherein the structural unit comprises a word line and a first bit line, both the word line and the first bit line are perpendicular to the voltage control line, and the plurality of storage strings in each structural unit are separately connected to the word line and the first bit line;
grounding a second bit line corresponding to the storage string to which the to-be-written storage unit belongs, and applying a write voltage to another second bit line, wherein the second bit line is parallel to the voltage control line, and the second bit line is connected to the transistor in the storage string;
applying a bias voltage to the storage unit by using a voltage control line connected to the to-be-written storage unit; and
writing data to the to-be-written storage unit based on the write voltage and the bias voltage.

13. A data write method for a magnetic random access memory, wherein the method comprises:
determining a structural unit to which a to-be-written storage unit belongs, wherein the magnetic random access memory comprises a plurality of structural units, planes on which the plurality of structural units are located are parallel to each other, each of the plurality of structural units comprises a plurality of storage strings parallel to each other, each of the plurality of storage strings comprises a plurality of layers of storage structures that are sequentially stacked, each of the plurality of layers of storage structures comprises a spin-orbit torque SOT electrode line and a storage unit disposed on the SOT electrode line, the storage unit comprises a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying, by using a word line corresponding to the structural unit, a gate bias voltage to a transistor in a storage string to which the to-be-written storage unit belongs, and grounding a first bit line corresponding to the structural unit, wherein the structural unit comprises a word line and a first bit line, both the word line and the first bit line are perpendicular to the voltage control line, and the plurality of storage strings in each structural unit are separately connected to the word line and the first bit line;
applying a write voltage to the to-be-written storage unit by using a second bit line corresponding to the storage string to which the to-be-written storage unit belongs, and grounding another second bit line, wherein the second bit line is parallel to the voltage control line, and the second bit line is connected to the transistor in the storage string;
applying a bias voltage to the storage unit by using a voltage control line connected to the to-be-written storage unit; and
writing data to the to-be-written storage unit based on the write voltage and the bias voltage.

14. A data read method for a magnetic random access memory, wherein the method comprises:
determining a target structural unit corresponding to a to-be-read storage string, wherein the magnetic random access memory comprises a plurality of structural units, planes on which the plurality of structural units are located are parallel to each other, each of the plurality of structural units comprises a plurality of storage strings parallel to each other, each of the plurality of storage strings comprises a plurality of layers of storage structures that are sequentially stacked, each of the plurality of layers of storage structures comprises a spin-orbit torque SOT electrode line and a storage unit disposed on the SOT electrode line, the storage unit comprises a magnetic tunnel junction, one terminal of the storage unit is connected to a voltage control line, the other terminal of the storage unit is connected to the SOT electrode line, the SOT electrode line is perpendicular to the voltage control line, and all SOT electrode lines in each storage string are connected in series by using metal wires;
applying a gate bias voltage to a transistor in the to-be-read storage string by using a word line corresponding to the target structural unit, where each structural unit comprises a word line and a first bit line, both the word line and the first bit line are perpendicular to the voltage control line, and the plurality of storage strings in each structural unit are separately connected to the word line and the first bit line;
applying a read voltage to both the voltage control line and the first bit line;
grounding a second bit line corresponding to the transistor in the to-be-read storage string, wherein another second bit line is used to apply a read voltage, the second bit line is parallel to the voltage control line, and the second bit line is connected to the transistor in the storage string; and
determining, based on the read voltage or the read current, the data corresponding to the to-be-read storage string.

15. An electronic device, comprising a processor, and a magnetic random access memory, coupled to the processor, according to any one of claims 1 to 11.
